# EUROPEAN PATENT APPLICATION

(11) **EP 4 764 554 A1**
(43) Date of publication of application: **24.06.2026**
(21) Application number: 25863923.6
(22) Date of filing: 20.08.2025
(51) Int. Cl.: G01R 31/392, G01R 31/382, G01R 19/10, G01R 19/165, G01R 31/367, H01M 10/48

(54) **BATTERY DIAGNOSIS DEVICE AND OPERATION METHOD THEREOF**

(30) Priority: 09.09.2024 KR 20240122594
(71) Applicant: LG Energy Solution, Ltd., Seoul 07335 (KR)
(72) Inventor: CHO, Hyo Seok, Daejeon 34122 (KR)
(74) Representative: Plasseraud IP
(86) International application number: PCT/KR2025/012631
(87) International publication number: WO 2026/054374

(57) **Abstract**

A battery diagnostic device according to an embodiment disclosed herein may include an interface configured to acquire a voltage value of one or more battery cells measured during a designated time interval and acquire an external temperature of the battery cells, and a controller configured to calculate a difference between voltage values at two points in time included in the designated time interval, select a discharge threshold corresponding to the external temperature and a target point in time of the two points in time, and diagnose a state of the battery cells by comparing the discharge threshold with the difference.

## Description

### TECHNICAL FIELD

### Cross-reference to Related Applications

This application claims priority from Korean Patent Application No. 10-2024-0122594, filed on September 9, 2024, the disclosures of which are incorporated by reference herein.

### Technical Field

Embodiments disclosed herein relate to a battery diagnostic device and a method of operating the same.

### BACKGROUND ART

In recent years, research and development for secondary batteries have been actively conducted. Here, the secondary battery is a battery capable of recharging and discharging, and in its meaning, includes all of the existing Ni/Cd battery, Ni/MH battery, and the like and a recent lithium-ion battery. Among secondary batteries, the lithium-ion battery has the advantage of having a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

As the industrial fields utilizing batteries expand, a battery management system (BMS) that diagnoses the safety of batteries is also developing. The BMS may diagnose battery performance utilizing various diagnostic algorithms. Here, "abnormality" may include all causes that may lead to ignition due to damage or aging of the battery itself.

In addition, the BMS may detect low-voltage cells by sensing current and/or voltage values of the battery and perform appropriate control, such as cell balancing, depending on the state of the battery.

### DISCLOSURE OF THE INVENTION

### TECHNICAL PROBLEM

A low-voltage cell refers to a battery cell whose voltage significantly decreases compared to other battery cells during a rest period. The low-voltage cell may cause a voltage imbalance between cells. As a result, when a low-voltage cell is not detected, cell balancing for equalizing voltages among battery cells is unnecessarily performed, which may cause a problem that the usage efficiency of a battery pack including the low-voltage cell is reduced. Accordingly, there is a need for a technology for early detection of a low-voltage cell.

The technical problems of the embodiments disclosed herein are not limited to those mentioned above, and other objectives not mentioned will be clearly understood by those skilled in the art from the following descriptions.

### TECHNICAL SOLUTION

According to an embodiment disclosed herein, a battery diagnostic device includes an interface configured to acquire a voltage value of one or more battery cells measured during a designated time interval and acquire an external temperature of the battery cells, and a controller configured to calculate a difference between voltage values at two points in time included in the designated time interval, select a discharge threshold corresponding to the external temperature and a target point in time of the two points in time, and diagnose a state of the battery cells by comparing the discharge threshold with the difference.

In an embodiment, the controller may select the discharge threshold from among a plurality of threshold voltage values based on a lookup table (LUT) including the plurality of threshold voltage values preset based on the external temperature and the target point in time.

In an embodiment, the interface may further acquire a state of health (SOH) of the battery cell, and the controller may select the discharge threshold further in consideration of the SOH.

In an embodiment, the controller may select a lookup table corresponding to the SOH from among a plurality of SOC-specific lookup tables including a plurality of threshold voltage values depending on the external temperature and the target point in time, and may select the discharge threshold from among the plurality of threshold voltage values included in the selected lookup table.

In an embodiment, the designated time may be included in a rest period of the battery.

In an embodiment, the two points in time may include a first point in time and a second point in time, the first point in time may be the earliest point in time at which the voltage value is acquired, and the second point in time may correspond to a point in time at which m measurement cycles (where m is a natural number) have elapsed from the first point in time.

In an embodiment, the target point in time may correspond to the second point in time.

In an embodiment, the controller may diagnose the battery cell as a low-voltage battery cell when the difference is greater than or equal to the discharge threshold.

According to an embodiment disclosed herein, a method of operating a battery diagnostic device includes acquiring a voltage value of one or more battery cells measured during a designated time interval, acquiring an external temperature of the battery cells, calculating a difference between voltage values at two points in time included in the designated time, selecting a discharge threshold corresponding to the external temperature and a target point in time of the two points in time, and diagnosing a state of the battery cells by comparing the discharge threshold with the difference.

In an embodiment, the selecting of the discharge threshold may include selecting the discharge threshold from among a plurality of voltage values based on a lookup table (LUT) including the plurality of threshold voltage values preset based on the external temperature and the target point in time.

In an embodiment, the method may further include acquiring a state of health (SOH) of the battery cell, and the selecting of the discharge threshold may include selecting the discharge threshold further in consideration of the SOH.

In an embodiment, the selecting of the discharge threshold may include selecting a lookup table corresponding to the SOH from among a plurality of SOC-specific lookup tables including a plurality of threshold voltage values depending on the external temperature and the target point in time and selecting the discharge threshold from among the plurality of threshold voltage values included in the selected lookup table.

In an embodiment, the designated time may be included in a rest period of the battery.

In an embodiment, the two points in time may include a first point in time and a second point in time, the first point in time may be the earliest point in time at which the voltage value is acquired, and the second point in time may correspond to a point in time at which m measurement cycles (where m is a natural number) have elapsed from the first point in time.

In an embodiment, the target point in time may correspond to the second point in time.

In an embodiment, the diagnosing may include diagnosing the battery cell as a low-voltage battery cell when the difference is greater than or equal to the discharge threshold.

### ADVANTAGEOUS EFFECTS

A battery diagnostic device according to various embodiments disclosed herein and a method of operating the same can detect a low-voltage battery cell by diagnosing the state of the battery cell based on the timing of measuring the voltage of the battery cell and the external temperature of the battery cell, taking into account the characteristics of the battery cell in which the discharge amount changes depending on temperature.

The effects of the battery diagnostic device and the method of operating the same according to the disclosure herein are not limited to the effects mentioned above, and other effects not mentioned will be clearly understood by those skilled in the art according to the disclosure herein.

### BRIEF DESCRIPTION OF THE DRAWINGS

FIG. 1 is a block diagram illustrating a battery diagnostic system according to an embodiment disclosed herein.
FIG. 2 illustrates a block diagram of a battery pack including a battery diagnostic device according to an embodiment disclosed herein.
FIG. 3 illustrates a discharge graph at different temperatures according to an embodiment disclosed herein.
FIG. 4 illustrates a lookup table including preset threshold voltage values according to an embodiment disclosed herein.
FIGS. 5a and 5b illustrate SOH-specific lookup tables including preset threshold voltage values according to an embodiment disclosed herein.
FIG. 6 is a flowchart showing a method of operating a battery diagnostic device according to an embodiment disclosed herein.
FIG. 7 illustrates a computing system for executing operations of the battery diagnostic device according to an embodiment disclosed herein.

With respect to the description of the drawings, the same or similar reference signs may be used for the same or similar elements.

### MODE FOR CARRYING OUT THE INVENTION

Hereinafter, embodiments of the present invention will be described with reference to the accompanying drawings. However, this is not intended to limit the present invention to the specific embodiments, and it is to be construed to include various modifications, equivalents, and/or alternatives of embodiments of the present invention.

It should be appreciated that embodiments of the present disclosure and the terms used therein are not intended to limit the technological features set forth herein to a particular embodiment and include various changes, equivalents, or replacements in corresponding embodiments. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," "first," "second," "A." "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

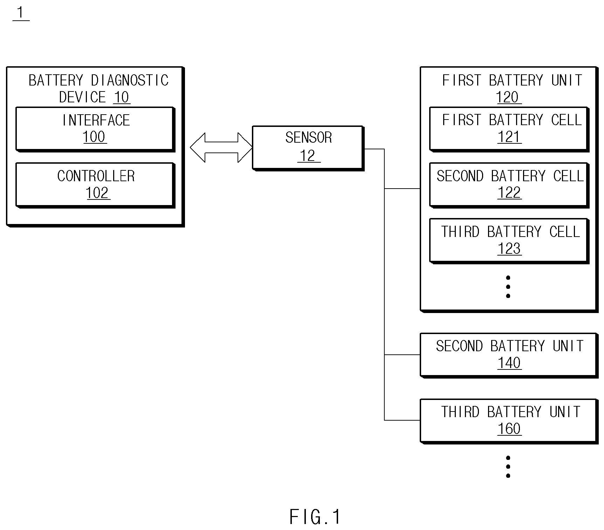

FIG. 1 is a block diagram illustrating a battery diagnostic system according to an embodiment disclosed herein.

Referring to FIG. 1, the battery diagnostic system 1 may include a battery diagnostic device 10, a sensor 12, and one or more battery units 120, 140, and 160.

The battery diagnostic device 10 may be connected to the sensor 12 by wire and/or wirelessly. The sensor 12 may include one or more sensors (e.g., a voltage measurement sensor, a temperature measurement sensor). The sensor 12 may measure values related to a state of each of the battery units 120, 140, and 160 and/or battery cells 121, 122, and 123. The sensor 12 may measure values related to a state of each of the battery units 120, 140, and 160 and/or battery cells 121, 122, and 123 at predetermined intervals (e.g., every 100 seconds). Here, values related to the state may represent one or more values for a voltage, a current, a resistance, a state of charge (SOC), a state of health (SOH), a battery internal temperature and/or a battery external temperature of each of the battery units 120, 140, and 160 and/or battery cells 121, 122, and 123, or a combination thereof. Hereinafter, the values related to state may be referred to as "state values."

In an embodiment, the sensor 12 may be connected to one or more battery units 120, 140, and 160 by wire and/or wirelessly to acquire the state values of the battery units 120, 140, and 160. Each of the one or more battery units 120, 140, and 160 may be a battery module, a battery pack, or a battery rack. In FIG. 1, only a first battery unit 120 to a third battery unit 160 are disclosed, but this is for convenience of description and the number of battery units is not limited thereto. In addition, in FIG. 1, the battery cells 121, 122, and 123 are illustrated as being included in the first battery unit 120, but this is only for convenience of description, and each of a second battery unit 140 and the third battery unit 160 may also include one or more battery cells. In addition, although in FIG. 1, the number of battery cells 121, 122, and 123 included in the first battery unit 120 is illustrated as three, the number is not limited thereto, and each of the battery cells 121, 122, and 123 may be configured to include two or more battery cells.

In an embodiment, the sensor 12 and one or more battery units 120, 140, and 160 may be included in an electronic device. Here, the electronic device may be a mobile device (e.g., a mobile phone, a laptop computer, a smartphone, or a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

The battery diagnostic device 10 may be included in a server or PC external to the electronic device. The connection between the battery diagnostic device 10 and the electronic device may be a communication connection through a wired and/or wireless network. Here, the wired network may be based on local area network (LAN) communications, or power line communications. The wireless network may be based on a short-range communication network (e.g., Bluetooth, wireless fidelity (WiFi), or infrared data association (IrDA)), or a long-range communication network (e.g., a cellular network, a 4G network, a 5G network). In an embodiment, the connection between the battery diagnostic device 10 and the electronic device may be a connection through a device-to-device communication method (e.g., bus, general purpose input and output (GPIO), serial peripheral interface (SPI), or mobile industry processor interface (MIPI)).

In an embodiment, the battery diagnostic device 10 may be included in a battery management system (BMS) capable of diagnosing battery units 120, 140, and 160 included in the electronic device, and operations performed in the battery diagnostic device 10 may be performed in the BMS.

In an embodiment, the battery diagnostic device 10 may be included in a server or a charger capable of diagnosing battery units 120, 140, and 160 outside the electronic device, and operations performed in the battery diagnostic device 10 may be performed in an external server or charger. In this case, the sensor 12 may not be included in the battery diagnostic device 10.

The battery diagnostic device 10 may acquire a voltage value of each of the battery units 120, 140, and 160 and/or battery cells 121, 122, and 123 measured by the sensor 12. The battery diagnostic device 10 may acquire the external temperature of the battery units 120, 140, and 160 and/or battery cells 121, 122, and 123 measured by the sensor 12. The battery diagnostic device 10 may calculate a difference between voltage values at two points in time included in a designated time interval. The battery diagnostic device 10 may select a discharge threshold corresponding to the external temperature and a target point in time among the two points in time. The battery diagnostic device 10 may diagnose the state of each of the battery units 120, 140, and 160 and/or battery cells 121, 122, and 123 by comparing the difference between the voltage values with the discharge threshold.

Hereinafter, a method of diagnosing the state of a first battery cell 121 illustrated in FIG. 1 by each of components included in the battery diagnostic device 10 will be described. However, this is only for convenience of description, and the battery diagnostic device 10 may diagnose the state of each of a plurality of battery cells 121, 122, and 123 simultaneously or at different times.

The battery diagnostic device 10 may include an interface 100 and one or more controllers 102. Here, a single interface 100 and a single controller 102 are referred to, but in some embodiments, a plurality of interfaces 100 and a plurality of controllers 102 may be provided, respectively. According to some embodiments, the battery diagnostic device 10 illustrated in FIG. 1 may further include at least one component (e.g., a display, an input device, or an output device) other than the components illustrated in FIG. 1.

The interface 100 may acquire a voltage value of the first battery cell 121 measured during a designated time interval. Here, the designated time interval may correspond to a specific time interval in charging periods and rest periods included in a process of charging the first battery cell 121. For example, the process of charging the first battery cell 121 may repeat the charging period and the rest period a plurality of times, and the designated time interval may be a time interval included in at least one rest period during the process of charging the first battery cell 121.

In an embodiment, the interface 100 may acquire, in real time, the voltage value of the first battery cell 121 measured by the sensor 12 (see FIG. 1). In an embodiment, the interface 100 may acquire the voltage value of the first battery cell 121 measured by the sensor 12 (see FIG. 1) after a certain time from the measurement time.

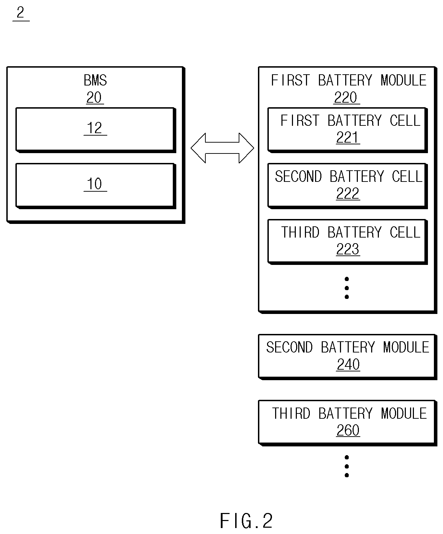

The interface 100 may acquire the external temperature of the first battery cell 121. In an embodiment, the external temperature may be the temperature outside a case of the first battery cell 121 that protects components (e.g., electrodes and separators) included in the first battery cell 121. In an embodiment, as illustrated in FIG. 1, when the first battery cell 121 is included in the first battery unit 120 (see FIG. 1), the external temperature may be the temperature outside the case of the first battery unit 120. In an embodiment, as illustrated in FIG. 2, when the first battery cell 121 is included in a first battery module 220 (see FIG. 2), the external temperature may be the temperature outside the case of the first battery module 220 or the temperature outside the case of a battery pack 2 (see FIG. 2).

In an embodiment, the interface 100 may acquire the external temperature measured by the sensor 12 (see FIG. 1) in real time. In an embodiment, the interface 100 may acquire the external temperature of the first battery cell 121 measured by the sensor 12 (see FIG. 1) after a certain time from the measurement time.

According to various embodiments, the interface 100 may include various interface circuits for acquiring signals, information, and/or data, such as sensors, communication circuits, or the like.

The controller 102 may calculate a difference between voltage values at two points in time included in the designated time interval. Here, the two points in time may include a first point in time and a second point in time, and the second point in time may correspond to a point in time at which m measurement cycles (m: natural number) have passed from the first point in time. For example, when a measurement cycle is 100 seconds, the first point in time corresponds to 0 seconds, and the second point in time corresponds to one measurement cycle after the first point in time, the second point in time may correspond to 100 seconds.

In an embodiment, the controller 102 may designate the first point in time as a fixed point in time (e.g., an initial point in time), designate the second point in time (e.g., the point in time after m measurement cycles have elapsed from the first point in time) as a variable, and calculate a difference therebetween. In an embodiment, the controller 102 may designate both the first point in time (e.g., the kth (k: natural number) measured point in time) and the second point in time (e.g., the (k+1)th measured point in time) as variables and calculate the difference.

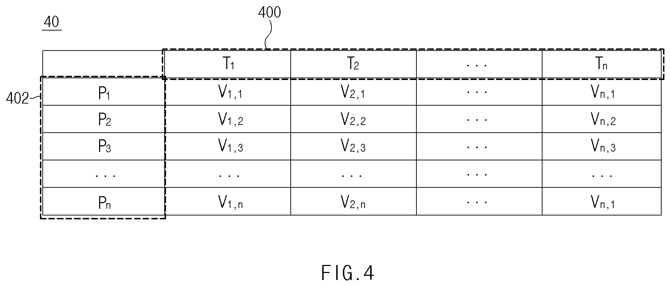

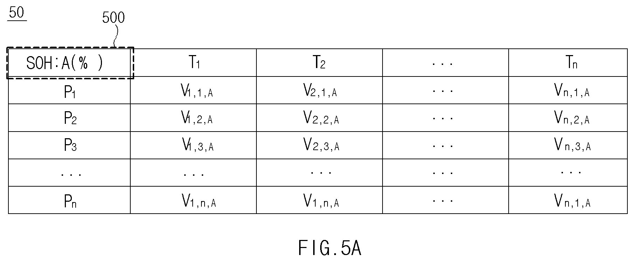

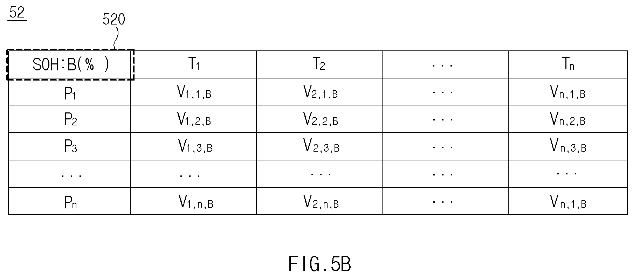

The controller 102 may select a discharge threshold corresponding to the external temperature and the target point in time among the two points in time. Here, the target point in time may correspond to one of the two points in time, and the discharge threshold may be one of a plurality of threshold values included in a lookup table (LUT) based on the external temperature and the target point in time. For example, the lookup table may include threshold values corresponding to target points in time for each external temperature. In an embodiment, the lookup table may be a lookup table based on the SOH and the target point in time, and the discharge threshold may be one of a plurality of threshold values included in the lookup table based on the SOH and the target point in time of the battery cell. For example, the lookup table may include threshold values corresponding to target points in time for each SOH of the battery cell. In an embodiment, the lookup table may include threshold voltage values obtained by further considering the SOH of the battery cell, and may include a plurality of SOH-specific lookup tables. According to the embodiment, the lookup table may be stored in a memory (not illustrated) included in the battery diagnostic device 10, or may be received by the battery diagnostic device 10 from an external server. Specific details regarding the discharge threshold are described below in FIGS. 4, 5a, and 5b.

The controller 102 may compare the discharge threshold with the difference. The controller 102 may diagnose the state of the first battery cell 121 based on a result of comparing the discharge threshold with the difference. In an embodiment, the controller 102 may diagnose the first battery cell 121 as a low-voltage cell when the difference is greater than or equal to the discharge threshold.

In an embodiment, when cell balancing is performed between two points in time at which voltage values are measured, the controller 102 may reflect a compensation value in the difference based on the result of the performed cell balancing. The controller 102 may diagnose the state of the first battery cell 121 by comparing the difference in which in the compensation value is reflected with the discharge threshold.

The battery diagnostic device 10 may perform, in real time, low-voltage diagnosis for the first battery cell 121 by comparing the difference with the discharge threshold. In addition, the battery diagnostic device 10 may also perform the low-voltage diagnosis for the first battery cell 121 later through the charging record for the pre-charged first battery cell 121. Based on the foregoing description, the battery diagnostic device 10 may prevent performance degradation caused by a low-voltage cell and fire caused by overcharging at an early stage by performing early detection of a low-voltage cell for the first battery cell 121.

FIG. 2 illustrates a block diagram of a battery pack including a battery diagnostic device according to an embodiment disclosed herein.

Referring to FIG. 2, a battery pack 2 may include a BMS 20 and battery modules 220, 240, and 260. The BMS 20 may include a battery diagnostic device 10 and, depending on the embodiment, may further include a sensor 12. In FIG. 2, three battery modules are illustrated, but this is only for convenience of description, and the battery pack 2 may include one or more battery modules. In addition, in FIG. 2, only the battery cells 221, 222, and 223 included in a first battery module 220 are illustrated, but this is only for convenience of description, and a second battery module 240 and a third battery module 260 may also include a plurality of battery cells. In addition, although in FIG. 2, the number of the plurality of battery cells 221, 222, and 223 included in the first battery module 220 is illustrated as three, the number is not limited thereto, and each of the battery cells 121, 122, and 123 may be configured to include two or more battery cells. In addition, the battery cells 221, 222, and 223 illustrated in FIG. 2 may be identical to the battery cells 121, 122, and 123 illustrated in FIG. 1.

According to various embodiments, when the battery pack 2 has a cell-to-pack (CTP) structure, the battery pack 2 may be configured to include a plurality of battery cells 121, 122, and 123 without distinction between the battery modules.

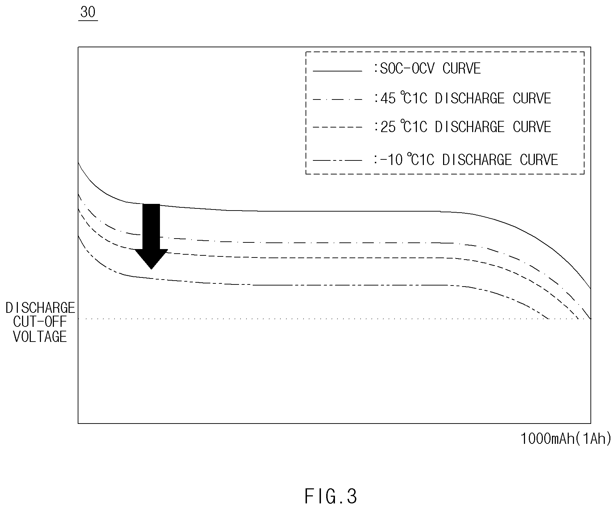

FIG. 3 illustrates a discharge graph at different temperatures according to an embodiment disclosed herein. FIG. 4 illustrates a lookup table including preset threshold voltage values according to an embodiment disclosed herein. FIGS. 5a and 5b illustrate SOH-specific lookup tables including preset threshold voltage values according to an embodiment disclosed herein. Hereinafter, the lookup table mentioned in FIGS. 1 and 2 will be described with reference to FIGS. 3 to 5b.

Referring to FIG. 3, a discharge graph 30 may be acquired through a discharge experiment on a normal battery cell conducted in advance. An x-axis of the discharge graph 30 may represent the capacity (unit: mAh or Ah) of the normal battery cell, and a y-axis may represent the voltage of the normal battery cell. Here, the normal battery cell may refer to a battery cell diagnosed as normal rather than a low-voltage cell.

Referring to the discharge graph 30, each of the discharge curves has the same C-rate (e.g., 1C), while the discharge curves differ in external temperatures of 45 degrees Celsius, 25 degrees Celsius, and -10 degrees Celsius, respectively. Referring to the discharge graph 30, it can be confirmed that, as the external temperature of the normal battery cell decreases, the deviation from a SOC-OCV curve increases.

Based on the characteristics of the discharge graph 30, the lookup table mentioned in FIGS. 1 and 2 may be constructed. The aforementioned lookup table may include threshold voltage values depending on external temperatures based on the self-discharge amount of the normal battery confirmed for each external temperature through the discharge graph for the normal battery cell.

FIG. 4 illustrates a first lookup table 40 including a plurality of threshold values V_{1,1}, V_{1,2}, ..., V_{n,1} preset based on external temperatures 400 and a target points in time 402, as an example of the lookup table described above. Here, the target point in time 402 may be a point in time corresponding to a second point in time among a first point in time and the second point in time included in a designated time interval (e.g., a rest period). For example, when the first point in time is 0 seconds and the second point in time is 100 seconds, a target point in time P₂ may be 100 seconds corresponding to the second point in time. A plurality of preset threshold values may be values calculated through a previously performed experiment based on the discharge characteristics of the normal battery cell depending on the external temperatures based on the discharge graph 30 of FIG. 3.

The first lookup table 40 may include threshold voltage values preset depending on the external temperatures 400 and the target points in time 402. Referring to the first lookup table 40, when the external temperature 400 is T₁, the voltage value at the first point in time is V₁, and the voltage value at the second point in time is V₂, the battery diagnostic device 10 may calculate the difference (V₁ - V₂) and select V_{1,2}, which is a discharge threshold corresponding to the difference.

In FIG. 4, the first lookup table 40 including the plurality of threshold values V_{1,1}, V_{1,2}, ..., V_{n,1} preset based on the external temperatures 400 and the target points in time 402 is illustrated, but the embodiments of the present invention are not limited thereto. In an embodiment, the battery diagnostic device 10 may select a discharge threshold using a lookup table including a plurality of threshold values preset based on the SOH and the target points in time 402. In another embodiment, as described later in FIGS. 5a and 5b, the battery diagnostic device 10 may select a discharge threshold using a lookup table including a plurality of threshold values preset based on the SOH and the external temperatures. In summary, the battery diagnostic device 10 may select a discharge threshold using a lookup table including threshold values preset based on the SOH and/or the external temperature.

FIGS. 5a and 5b each illustrate a second lookup table including a plurality of SOC-specific lookup tables 50 and 52, which are generated further in consideration of SOH in addition to the external temperatures and the target points in time, as an example of the lookup table described above. Referring to FIGS. 5a and 5b, the second lookup table may include a first sub-lookup table 50 having an SOH of A% 500 and a second sub-lookup table 52 having an SOH of B% 520.

The battery diagnostic device 10 may select the first sub-lookup table 50 from among the second lookup tables when the SOH of the first battery cell 121 is A% (500). The battery diagnostic device 10 may select a discharge threshold corresponding to the external temperature and target point in time of the first battery cell 121 among the threshold voltage values V_{1,1,A}, V_{1,2,A}, ..., and V_{n,1,A} included in the first sub-lookup table 50. Likewise, the battery diagnostic device 10 may select the second sub-lookup table 52 from among the second lookup tables when the SOH of the first battery cell 121 is B% (520). The battery diagnostic device 10 may select a discharge threshold corresponding to the external temperature and target point in time of the first battery cell 121 among the threshold voltage values V_{1,1,B}, V_{1,2,B}, ..., and V_{n,1,B} included in the second sub-lookup table 52.

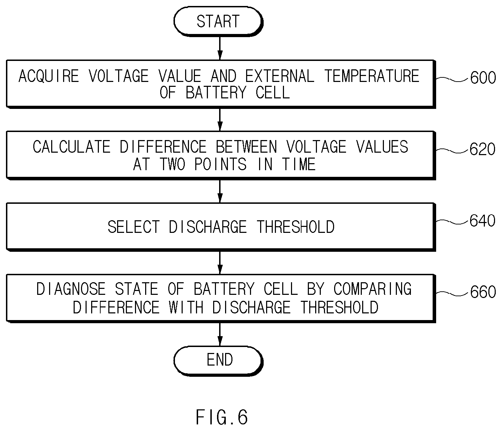

FIG. 6 is a flowchart showing a method of operating a battery diagnostic device according to an embodiment disclosed herein.

Referring to FIG. 6, in operation 600, the battery diagnostic device 10 may acquire a voltage value and external temperature of the first battery cell 121.

The battery diagnostic device 10 may acquire a voltage value of the first battery cell 121 measured during a designated time interval. The battery diagnostic device 10 may acquire, in real time, the voltage value of the first battery cell 121 measured by the sensor 12 (see FIG. 1).

In an embodiment, the battery diagnostic device 10 may acquire the voltage value of the first battery cell 121 measured by the sensor 12 (see FIG. 1) after a certain time from a measurement time.

The battery diagnostic device 10 may acquire the external temperature of the first battery cell 121. In an embodiment, the external temperature may be the temperature outside a case of the first battery cell 121 that protects components (e.g., electrodes and separators) included in the first battery cell 121. In an embodiment, as illustrated in FIG. 1, when the first battery cell 121 is included in the first battery unit 120 (see FIG. 1), the external temperature may be the temperature outside the case of the first battery unit 120. In an embodiment, as illustrated in FIG. 2, when the first battery cell 121 is included in a first battery module 220 (see FIG. 2), the external temperature may be the temperature outside the case of the first battery module 220 or the temperature outside the case of a battery pack 2 (see FIG. 2).

In an embodiment, the battery diagnostic device 10 may acquire the external temperature measured by the sensor 12 (see FIG. 1) in real time. In an embodiment, the battery diagnostic device 10 may acquire the external temperature of the first battery cell 121 measured by the sensor 12 (see FIG. 1) after a certain time from the measurement time.

In operation 620, the battery diagnostic device 10 may calculate a difference between voltage values at two points in time. The battery diagnostic device 10 may calculate a difference between voltage values at two points in time included in a designated time interval.

In an embodiment, the battery diagnostic device 10 may designate the first point in time as a fixed point in time (e.g., an initial point in time), designate the second point in time (e.g., the point in time after m measurement cycles have elapsed from the first point in time) as a variable, and calculate a difference therebetween.

In an embodiment, the battery diagnostic device 10 may designate both the first point in time (e.g., the kth (k: natural number) measured point in time) and the second point in time (e.g., the (k+1)th measured point in time) as variables and calculate the difference.

In operation 640, the battery diagnostic device 10 may select a discharge threshold. The battery diagnostic device 10 may select a discharge threshold corresponding to the external temperature and a target point in time among the two points in time. The battery diagnostic device 10 may select a discharge threshold based on a lookup table. In an embodiment, the lookup table may include at least one of the lookup tables 40, 50, and 52 disclosed in FIGS. 4, 5a, and 5b.

In operation 660, the battery diagnostic device 10 may diagnose the state of the first battery cell by comparing the difference with the discharge threshold. The battery diagnostic device 10 may diagnose the state of the first battery cell 121 based on a result of comparing the difference with the discharge threshold. In an embodiment, the battery diagnostic device 10 may diagnose the first battery cell 121 as a low-voltage cell when the difference is greater than or equal to the discharge threshold.

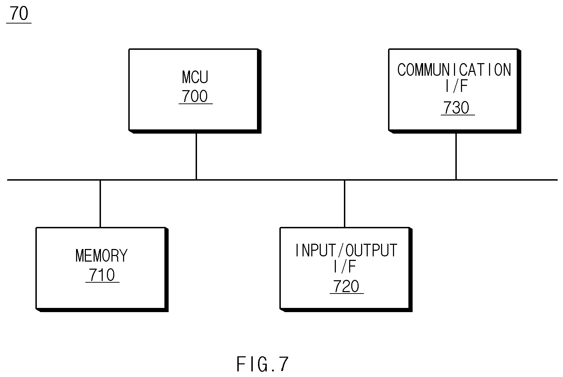

FIG. 7 illustrates a computing system for executing operations of the battery diagnostic device according to an embodiment disclosed herein.

Referring to FIG. 7, a computing system 70 according to an embodiment disclosed herein may include a microcontroller unit (MCU) 700, a memory 710, an input/output interface (I/F) 720, and a communication I/F 730.

The MCU 700 may be a processor that executes various programs (e.g., a battery diagnosis program) stored in the memory 710, processes various data from the programs, and performs functions of the battery diagnostic device 10 illustrated in FIGS. 1 to 6 described above.

The memory 710 may store various programs related to the operations of the battery diagnostic device 10. In addition, the memory 710 may store operating data of the battery diagnostic device 10.

A plurality of memories 710 may be provided as needed. The memory 710 may be a volatile memory or a non-volatile memory. As the volatile memory for the memory 710, a random-access memory (RAM), a dynamic RAM (DRAM), a static RAM (SRAM), or the like may be used. As the non-volatile memory for the memory 710, a read-only memory (ROM), a programmable ROM (PROM), an electrically alterable ROM (EAROM), an erasable programmable ROM (EPROM), an electrically erasable programmable ROM (EEPROM), a flash memory, or the like may be used. The examples of memories 710 listed above are only exemplary and are not limited to the examples.

The input/output I/F 720 may provide an interface that connects an input device (not shown) such as a keyboard, a mouse, a touch panel, or the like, and an output device such as a display (not shown), to the MCU 700 to enable data transmission and reception.

The communication I/F 730 is a component that may transmit and receive various data to and from the server, and may be any device that may support wired or wireless communication. For example, diagnostic algorithms, lookup tables, and the like may be transmitted and received from a separately provided external server through the communication I/F 730.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

## Claims

1. A battery diagnostic device comprising:
an interface configured to:
acquire a voltage value of one or more battery cells measured during a designated time interval; and
acquire an external temperature of the battery cells; and
a controller configured to:
calculate a difference between voltage values at two points in time included in the designated time interval;
select a discharge threshold corresponding to the external temperature and a target point in time of the two points in time; and
diagnose a state of the battery cells by comparing the discharge threshold with the difference.

2. The battery diagnostic device of claim 1, wherein the controller selects the discharge threshold from among a plurality of threshold voltage values based on a lookup table (LUT) including the plurality of threshold voltage values preset based on the external temperature and the target point in time.

3. The battery diagnostic device of claim 1, wherein the interface further acquires a state of health (SOH) of the battery cell, and
the controller selects the discharge threshold further in consideration of the SOH.

4. The battery diagnostic device of claim 3, wherein the controller is configured to:
select a lookup table corresponding to the SOH from among a plurality of SOC-specific lookup tables including a plurality of threshold voltage values depending on the external temperature and the target point in time; and
select the discharge threshold from among the plurality of threshold voltage values included in the selected lookup table.

5. The battery diagnostic device of claim 1, wherein the designated time is included in a rest period of the battery.

6. The battery diagnostic device of claim 1, wherein the two points in time include a first point in time and a second point in time,
the first point in time is the earliest point in time at which the voltage value is acquired, and
the second point in time corresponds to a point in time at which m measurement cycles (where m is a natural number) have elapsed from the first point in time.

7. The battery diagnostic device of claim 6, wherein the target point in time corresponds to the second point in time.

8. The battery diagnostic device of claim 1, wherein the controller diagnoses the battery cell as a low-voltage battery cell when the difference is greater than or equal to the discharge threshold.

9. A method of operating a battery diagnostic device, comprising:
acquiring a voltage value of one or more battery cells measured during a designated time interval;
acquiring an external temperature of the battery cells;
calculating a difference between voltage values at two points in time included in the designated time;
selecting a discharge threshold corresponding to the external temperature and a target point in time of the two points in time; and
diagnosing a state of the battery cells by comparing the discharge threshold with the difference.

10. The method of claim 9, wherein the selecting of the discharge threshold includes selecting the discharge threshold from among a plurality of voltage values based on a lookup table (LUT) including the plurality of threshold voltage values preset based on the external temperature and the target point in time.

11. The method of claim 9, further comprising acquiring a state of health (SOH) of the battery cell,
wherein the selecting of the discharge threshold includes selecting the discharge threshold further in consideration of the SOH.

12. The method of claim 11, wherein the selecting of the discharge threshold includes:
selecting a lookup table corresponding to the SOH from among a plurality of SOC-specific lookup tables including a plurality of threshold voltage values depending on the external temperature and the target point in time; and
selecting the discharge threshold from among the plurality of threshold voltage values included in the selected lookup table.

13. The method of claim 9, wherein the designated time is included in a rest period of the battery.

14. The method of claim 9, wherein the two points in time include a first point in time and a second point in time,
the first point in time is the earliest point in time at which the voltage value is acquired, and
the second point in time corresponds to a point in time at which m measurement cycles (where m is a natural number) have elapsed from the first point in time.

15. The method of claim 14, wherein the target point in time corresponds to the second point in time.

16. The method of claim 9, wherein the diagnosing includes diagnosing the battery cell as a low-voltage battery cell when the difference is greater than or equal to the discharge threshold.
